# EUROPEAN PATENT SPECIFICATION

(11) **EP 2 017 927 B1**
(45) Date of publication and mention of the grant of the patent: **13.02.2019**
(21) Application number: 08104799.5
(22) Date of filing: 18.07.2008
(51) Int. Cl.: H01S 5/068, H01S 5/0687, H01S 5/0683, H01S 5/024, H01S 5/026, H01S 5/06, H01S 5/0625

(54) **Method of controlling semiconductor laser**
Verfahren zur Steuerung eines Halbleiterlasers
Procédé de contrôle de laser semi-conducteur

(30) Priority: 19.07.2007 JP 2007188880
(43) Date of publication of application: 21.01.2009
(73) Proprietor: Sumitomo Electric Device Innovations, Inc., Yokohama-shi Kanagawa 244-0845 (JP)
(72) Inventor: Machida, Toyotoshi, Nakakoma-gun, Yamanashi 409-3883 (JP); Ishikawa, Tsutomu, Nakakoma-gun, Yamanashi 409-3883 (JP); Tanaka, Hirokazu, Nakakoma-gun, Yamanashi 409-3883 (JP)
(74) Representative: Haseltine Lake LLP

(56) References cited:
- EP-A- 1 804 349
- WO-A1-2008/039313
- US-A1- 2004 190 580
- US-A1- 2005 254 531
- US-A1- 2006 198 415
- US-B1- 6 219 362

## Description

### BACKGROUND OF THE INVENTION

### 1. Field of the Invention

The present invention relates to an optical device and a method of controlling the optical device.

### 2. Description of the Related Art

A wavelength-tunable semiconductor laser is an example of an optical device. The wavelength-tunable semiconductor laser has a gain for laser oscillation and selects wavelength. There is a method of tuning wavelength characteristics of loss, reflection or gain by tuning the refractive index of an optical functional region such as a diffraction grating provided in an optical waveguide in a resonator, as a method of selecting wavelength.

Such a method of tuning the refractive index does not need a mechanical movable portion, being different from a method of tuning a mechanical angle or a mechanical length. Therefore, the method has an advantage in reliability and a manufacturing cost. There exist a method of tuning the temperature of an optical waveguide, and a method of tuning the carrier density in an optical waveguide with current injection or the like, as methods of tuning the refractive index of an optical waveguide. There is proposed a semiconductor laser having a Sampled Grating Distributed Bragg Reflector (SG-DBR), in which the peak wavelength of reflection peak ranges periodically and Sampled Grating Distributed Feedback (SG-DFB) in which the peak wavelength of the gain spectrum ranges periodically, as a concrete example of a wavelength-tunable laser adopting a method of tuning the temperature of an optical waveguide.

This semiconductor laser controls the correlation between the reflection spectra of the SG-DBR and the SG-DFB, selects a wavelength with a Vernier effect, and emits laser light. That is, the semiconductor laser oscillates at a wavelength where two spectra overlap and the reflection intensity gets biggest. It is therefore possible to control the oscillation wavelength by controlling the correlation of two reflection spectra.

Japanese Patent Application Publication No. 9-92934 (hereinafter referred to as Document 1) discloses a semiconductor laser controlling the oscillation wavelength using control of the refractive index of an optical waveguide. In Document 1, a heater is adopted as a control portion for the refractive index of the optical waveguide. The wavelength is controlled by way of temperature control of the optical waveguide using the heater.

US 6219362 (Hillmer/Deutsche Telekom) discloses a method of setting a heating characteristic by trimming an additional resistor according to a temperature measurement.

US2004/0190580 (B. Pezeshki) discloses a controlling method for a semiconductor laser having a wavelength selection portion, whose refractive index is varied by a heater. A starting sequence includes a first step of determining if the heat dissipation of the heater is within a given range and adjusting it until it reaches a given value; a wavelength control sequence includes a second step of correcting the laser wavelength according to the detection result of the oscillation wavelength of the semiconductor laser after the starting sequence.

Degradation of the heater is a problem where the heater is used for a control of the refractive index of the optical waveguide. The heat value of the heater may change even if a constant current is provided to the heater, because the resistance of the heater changes as a result of the degradation of the heater. In particular, temperature differential between each optical waveguide is important and the unexpected changing of the heat value is fatal, in an optical device that has a combination of the optical waveguides having wavelength properties different from each other such as a combination of the SG-DFB and the SG-DBR.

The width of the temperature range (ΔT) of the heater for controlling the temperature of the optical waveguide is approximately 40 degrees. The temperature of the heater is relatively low. Therefore, the degradation of the heater has not been considered.

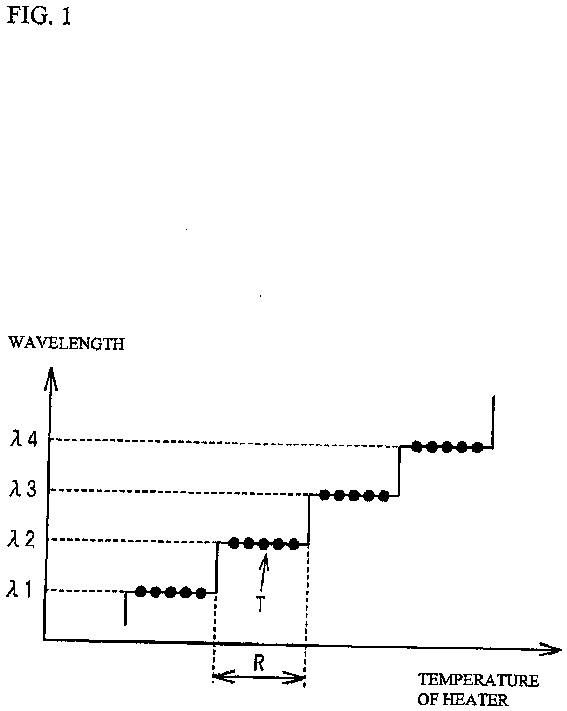

The degradation of the heater is difficult to monitor, where the semiconductor laser is used continuously. **FIG. 1** illustrates the relationship between the temperature of the heater and the oscillation wavelength of the semiconductor laser. The horizontal axis of FIG. 1 indicates the temperature of the heater. The vertical axis of FIG. 1 illustrates the oscillation wavelength of the semiconductor laser. For example, the semiconductor laser oscillates at a wavelength where two of the reflection spectra of the SG-DBR region and the SG-DFB region overlap. Therefore, the oscillation wavelength of the semiconductor laser profiles at a given wavelength interval. In FIG. 1, flat portions (λ1 to λ4) are wavelengths where the semiconductor laser may oscillate.

The temperature of the heater is set within a temperature range R of FIG. 1, in order to set the oscillation wavelength of the semiconductor laser to be λ2. For example, a current is provided to the heater so that the temperature of the heater is at a temperature T in the middle of the temperature range R. However, the resistance of the heater changes if the heater is degraded. In this case, the heat value of the heater changes. That is, the semiconductor laser may oscillate at a wavelength other than λ2 when the temperature of the heater is away from the temperature T.

However, a semiconductor laser adopting a feedback system for detecting the output wavelength and correcting the wavelength has a wavelength locker for correcting the output wavelength of the semiconductor laser. The wavelength locker controls the temperature of the temperature control device and changes the gain spectrum of the SG-DFB region to be matched with the desired wavelength λ2. Therefore, the oscillation wavelength of the semiconductor laser is kept to be λ2 when the temperature of the heater is within the temperature range R, even if the heater is degraded and the temperature of the heater is different from the temperature T. That is, the degradation of the heater is difficult to bring to light because the output wavelength is stabilized even if the heater is gradually degraded, when the wavelength is continuously corrected.

On the other hand, the problem is exposed when the system is shut down for maintenance. The current value of the heater and the temperature of the temperature control device are loaded from a look-up table when the system is restarted. The setting value of the look-up table is an initial value on the condition that the heater is not degraded. Therefore, the temperature of the heater is different from the temperature T if the heater is degraded. On the other hand, the temperature value of the look-up table is an initial value. Therefore, the gain spectrum of the SG-DFB region is different from the spectrum of the case where the wavelength locker corrects the wavelength.

For example, the semiconductor laser may oscillate at an expected wavelength λ2 when the heater is little degraded and the initial temperature of the heater is within the temperature range R. However, the semiconductor laser may oscillate at another wavelength, because the temperature T is not obtained because of the degradation of the heater. For example, the semiconductor laser may oscillate at other than the wavelength λ2, if the initial temperature value of the temperature control device and the initial current value of the SG-DFB are not given to the laser chip accurately. That is, the oscillation wavelength is susceptible to the parameter movement.

The semiconductor laser may not oscillate at the wavelength λ2 even if the other parameter is controlled accurately, when the heater is degraded and the temperature of the heater is out of the temperature range R. At any rate, it is difficult to obtain the desired wavelength upon restarting if the heater is degraded.

### SUMMARY OF THE INVENTION

The present invention aims to provide a method of controlling a semiconductor laser that obtains a desired wavelength even if the heater is degraded.

According to an aspect of the present invention, there is provided a method of controlling a semiconductor laser as defined in claim 1. Further embodiments are defined in claims 2 - 10.

For a better understanding of the invention, embodiments of it will now be described, by way of example, with reference to the accompanying drawings, in which:
- FIG. 1: illustrates the relationship between the temperature of a heater and the oscillation wavelength of a semiconductor laser;
- FIG. 2: illustrates a semiconductor laser in accordance with a first embodiment and the structure of a laser device having the semiconductor laser;
- FIG. 3: illustrates an example of a look-up table;
- FIG. 4: illustrates a flowchart showing an example of a control method for the laser device; and
- FIG. 5: illustrates a flowchart showing an example of a control method in a case where a semiconductor laser is dark-tuned.

### [First Embodiment]

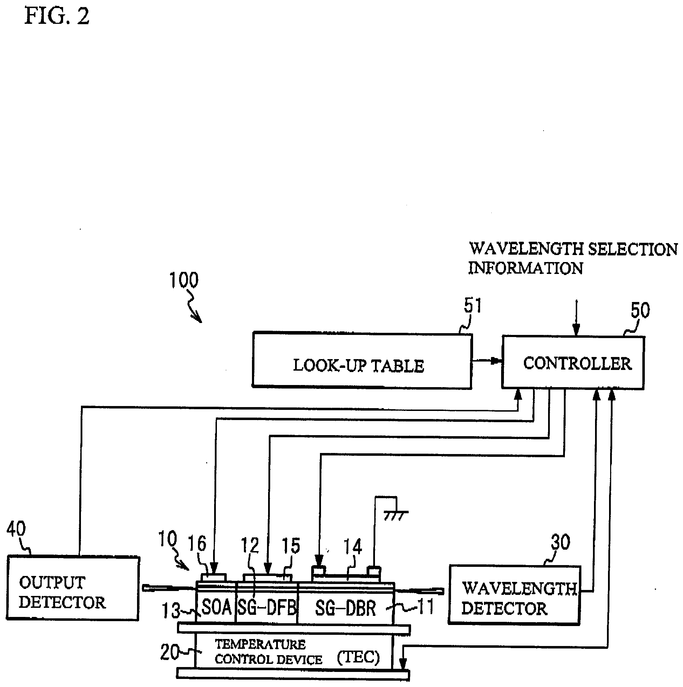

**FIG. 2** illustrates a semiconductor laser 10 in accordance with a first embodiment and the structure of a laser device 100 having the semiconductor laser 10. As shown in FIG. 2, the laser device 100 has the semiconductor laser 10, a temperature control device 20, a wavelength detector 30, an output detector 40 and a controller 50. The semiconductor laser 10 is mounted on the temperature control device 20. A description will be given of each part.

The semiconductor laser 10 has a structure in which a SG-DBR region 11, a SG-DFB region 12 and a semiconductor amplifier (SOA: Semiconductor Optical Amplifier) region 13 are coupled in order. The SG-DBR region 11 has an optical waveguide in which gratings are provided at a given interval. That is, the optical waveguide of the SG-DBR region 11 has a first region that has a diffraction grating and a second region that is optically connected to the first region and acts as a spacer. The optical waveguide of the SG-DBR region 11 is composed of semiconductor crystal having an absorption edge wavelength on the shorter wavelength side compared to the laser oscillation wavelength. A heater 14 is provided on the SG-DBR region 11.

The SG-DFB region 12 has an optical waveguide in which gratings are provided at a given interval. That is, the optical waveguide of the SG-DFB region 12 has a first region that has a grating and a second region that is optically connected to the first region and acts as a spacer. The optical waveguide of the SG-DFB region 12 is composed of semiconductor crystal amplifying light of a desired wavelength of a laser oscillation. An electrode 15 is provided on the SG-DFB region 12. The SOA region 13 has an optical waveguide composed of semiconductor crystal for amplifying light or for absorbing light with a current control. An electrode 16 is provided on the SOA region 13. The optical waveguides of the SG-DBR region 11, the SG-DFB region 12 and the SOA region 13 are optically connected to each other.

The semiconductor laser 10 is mounted on the temperature control device 20. A thermistor (not shown) for detecting the temperature of the temperature control device 20 is provided on the temperature control device 20. The wavelength detector 30 has a light-receiving element for detecting the intensity of a lasing light and a light-receiving element for detecting the intensity of a lasing light that passes through an etalon and has wavelength property. The output detector 40 has a light-receiving element for detecting the intensity of lasing light passing through the SOA region 13. In FIG. 2, the wavelength detector 30 is arranged on the side of the SG-DBR region 11, and the output detector 40 is arranged on the side of the SOA region 13. However, the structure of the semiconductor laser 10 is not so limited. For example, the detectors may be arranged in reverse.

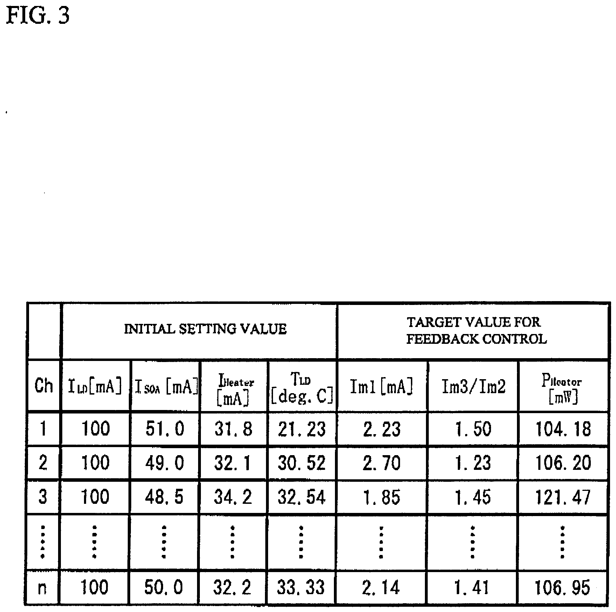

The controller 50 has a control portion having a central processing unit (CPU), a random-access memory (RAM), a read-only memory (ROM) and so on and an electrical power supply. The ROM of the controller 50 stores control information and a control program for the semiconductor laser 10. The control information is, for example, stored in a look-up table 51. **FIG. 3** illustrates an example of the look-up table 51.

As shown in FIG. 3, the look-up table 51 includes an initial setting value and a target value for feedback control in every channel. The initial setting value includes an initial current value ILD of the SG-DFB region 12, an initial current value I_{SOA} of the SOA region 13, an initial current value I_{Heater} of the heater 14 and the initial temperature value T_{LD} of the temperature control device 20. The target value for the feedback control includes a target value Im1 for feedback control of the output detector 40, a target value Im3/Im2 for feedback control of the wavelength detector 30 and a target value P_{Heater} for feedback control of electrical power of the heater 14.

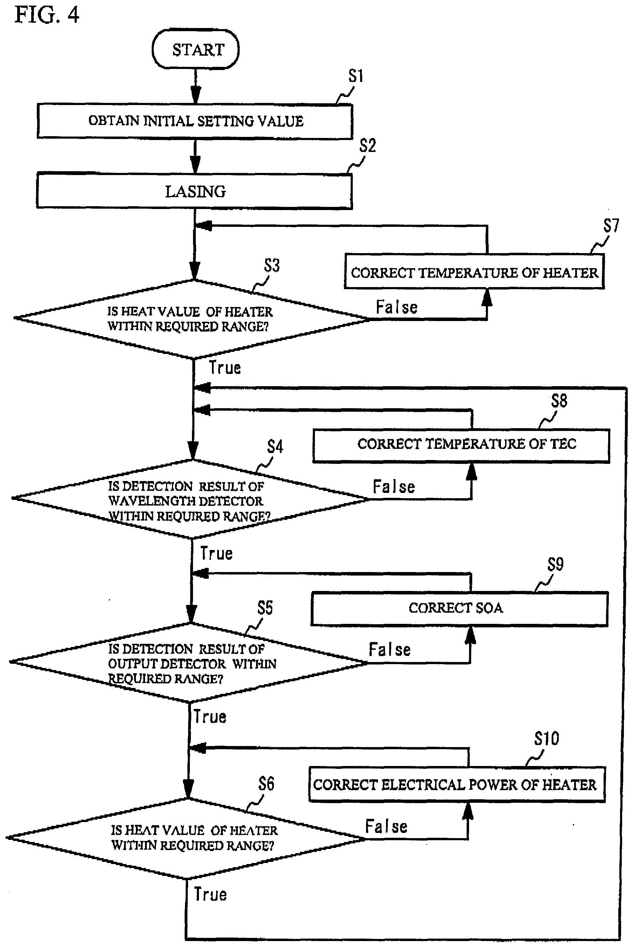

Next, a description will be given of a control method of the laser device 100. **FIG. 4** illustrates a flowchart showing a controlling method of the semiconductor laser 10. As shown in FIG. 4, the controller 50 refers to the look-up table 51 and obtains the initial current value I_{LD}, the initial current value I_{SOA}, the initial current value I_{Heater} and the initial temperature value TLD (Step S1).

Next, the controller 50 starts a laser oscillation of the semiconductor laser 10 according to the initial setting value obtained in Step S1 (Step S2). In concrete terms, the controller 50 controls the temperature control device 20 so that its temperature is at the initial temperature value T_{LD}. Further, the temperature of the semiconductor laser 10 is controlled to be constant, near the initial temperature value T_{LD}. Consequently the equivalent refractive index of the optical waveguide of the SG-DFB region 12 is controlled. Next, the controller 50 provides a current of the initial current value ILD to the electrode 15, and light is generated in the optical waveguide of the SG-DFB region 12. The light generated in the SG-DFB region 12 is repeatedly reflected and amplified in the optical waveguide of the SG-DBR region 11 and the SG-DFB region 12. This results in laser oscillation. Next, the controller 50 provides a current of the initial current value I_{Heater} to the heater 14. Therefore, the equivalent refractive index of the optical waveguide of the SG-DBR region 11 is controlled to be a given value. Then, the controller 50 provides a current of the initial current value I_{SOA} to the electrode 16. With this control, the semiconductor laser 10 emits lasing light at an initial wavelength corresponding to a set channel.

Then, the controller 50 determines whether the heat value of the heater 14 is within a required range according to the electrical power obtained with a voltage applied between both ends of the heater 14 and a current provided to the heater 14 (Step S3). In concrete terms, the controller 50 obtains the target value P_{Heater} for feedback control from the look-up table 51. After that, the controller 50 determines whether the electrical power obtained with the detected voltage of the heater 14 and the current provided to the heater 14 is within a given range including the target value P_{Heater} for feedback control.

If it is not determined that the heat value of the heater 14 is within the required range in Step S3, the controller 50 corrects the temperature of the heater 14 (Step S7). The temperature of the heater 14 is corrected when the current provided to the heater 14 is changed and the electrical power obtained with the current provided to the heater 14 and the voltage applied between the ends of the heater 14 is changed. After that, the controller 50 executes Step S3 again. With the loop, the heat value of the heater 14 is feedback-controlled so as to be within the required range.

Next, the controller 50 determines whether the wavelength of the lasing light is within a required range according to the detection result of the wavelength detector 30 (Step S4). In concrete terms, the controller 50 obtains the target value Im3/Im2 for feedback control from the look-up table 51, obtains a ratio Im3/Im2 from the two light-receiving elements in the wavelength detector 30 and determines whether the ratio Im3/Im2 is within a given range including the target value Im3/Im2 for feedback control.

If it is not determined that the wavelength of the lasing light is within the required range in Step S4, the controller 50 corrects the temperature of the temperature control device 20 (Step S8). In this case, the peak wavelength of the gain spectrum in the optical waveguide in the SG-DFB region 12 changes. After that, the controller 50 executes Step S4 again. With the loop, the wavelength of the lasing light is feedback-controlled so as to be kept at a desired constant value.

If it is determined that the wavelength of the lasing light is within the required range in Step S4, the controller 50 determines whether the optical intensity of the lasing light is within a required range (Step S5). In detail, the controller 50 obtains the target value Im1 for feedback control from the look-up table 51, obtains the detection result Im1 of the light-receiving element in the output detector 40, and determines whether the detection result Im1 is within a given range including the target value Im1 for feedback control.

If it is not determined that the optical intensity of the lasing light is within the required range in Step S5, the controller 50 corrects the current provided to the electrode 16 (Step S9). After that, the controller 50 executes Step S5 again. With the loop, the optical intensity of the lasing light is feedback-controlled to a desired constant value.

If it is determined that the optical intensity of the lasing light is within the required range in Step S5, the controller 50 determines whether the heat value of the heater 14 is within a required range (Step S6). In concrete terms, the controller 50 obtains the target value P_{Heater} from the look-up table 51, obtains the voltage applied between the both ends of the heater 14, and determines whether the electrical power calculated with the voltage and the current value provided to the heater 14 is within a required range including the target value P_{Heater} for feedback control.

If it is not determined that the heat value of the heater 14 is within the required range in Step S6, the controller 50 corrects the electrical power to the heater 14 (Step S10). In this case, the electrical power is corrected by altering at least one of the current and the voltage. In the embodiment, the controller 50 corrects the electrical power by increasing and decreasing the current value provided to the heater 14. With the loop, the electrical power provided to the heater 14 is feedback-controlled so that the electrical power provided to the heater 14 is controlled to be within the required range. If it is determined that the electrical power provided to the heater 14 is within the required range in the Step S6, the controller 50 executes Step S4 again.

In the embodiment, the heat value of the heater 14 is corrected accurately before the wavelength is controlled with the wavelength detector 30. In this case, the heat value of the heater 14 is substantially the same as a case where the heater is little degraded, even if the heater 14 is degraded. Therefore, the optical property of the SG-DBR region 11 is substantially the same as a case where the heater 14 is little degraded. This results in a desirable wavelength according to the initial setting value.

In the flowchart in FIG. 4, the oscillation wavelength and the intensity of the emitted light are controlled. However, the flowchart is not limited. Another micro controller may execute the loop of Step S4 through Step S8 or the loop of the Step S5 and the Step S9.

Next, a description will be given of a method of controlling the laser device 100 in a case of dark tuning. Dark tuning is a method of blocking or preventing optical output until the lasing wavelength reaches the required wavelength range. In the embodiment, the lasing wavelength of the semiconductor laser 10 is adjusted under a condition where a reverse voltage is applied to the SOA region 13 and the optical output is forbidden.

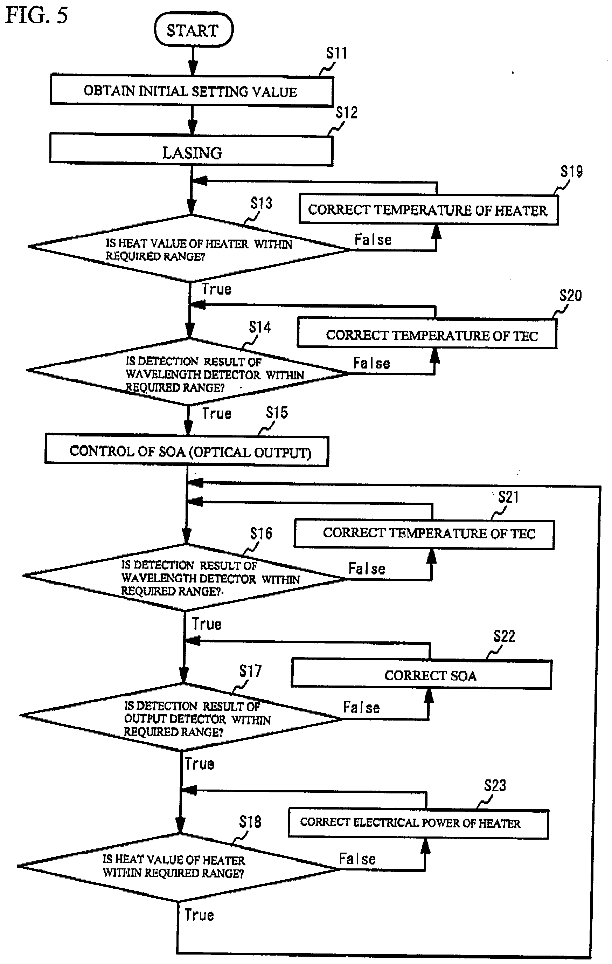

**FIG. 5** illustrates a flowchart showing an example of the dark tuning of the laser device 100. As shown in FIG. 5, the controller 50 refers to the look-up table 51 and obtains the initial current value I_{LD}, the initial current value I_{SOA}, the initial current value I_{Heater} and the initial temperature value T_{LD} (Step S11).

Next, the controller 50 starts a laser oscillation of the semiconductor laser 10 according to the initial setting value obtained in the Step S11 (Step S12). In detail, the controller 50 controls the temperature control device 20 so that the temperature control device 20 is controlled to be at the initial temperature value T_{LD}. Next, the controller 50 provides a current of the initial current value I_{LD} to the electrode 15. Next, the controller 50 provides a current of the initial current value I_{Heater} to the heater 14. Then, the light generated in the SG-DFB region 12 is repeatedly reflected and amplified in the optical waveguide of the SG-DBR region 11 and the SG-DFB region 12. This results in a laser oscillation.

Then, the controller 50 determines whether the heat value of the heater 14 is within a required range (Step S13). In detail, the controller 50 obtains the target value P_{Heater} for feedback control from the look-up table 51. After that, the controller 50 determines whether the electrical power obtained with the detected voltage of the heater 14 and the current provided to the heater 14 is within a given range including the target value P_{Heater} for feedback control.

If it is not determined that the heat value of the heater 14 is within the required range in Step S13, the controller 50 corrects the temperature of the heater 14 (Step S19). After that, the controller 50 executes Step S3 again.

Next, the controller 50 determines whether the wavelength of the lasing light is within a required range according to the detection result of the wavelength detector 30 (Step S14). In detail, the controller 50 obtains the target value Im3/Im2 for feedback control from the look-up table 51, obtains a ratio Im3/Im2 of the two light-receiving elements in the wavelength detector 30 and determines whether the ratio Im3/Im2 is within a given range including the target value Im3/Im2 for feedback control.

If it is not determined that the wavelength of the lasing light is within the required range in the Step S14, the controller 50 corrects the temperature of the temperature control device 20 (Step S20). After that, the controller 50 executes Step S14 again.

If it is determined that the wavelength of the lasing light is within the required range in Step S14, the controller 50 provides a current of the initial current value I_{SOA} to the electrode 16 (Step S15). Therefore, the semiconductor laser 10 emits laser light at the initial wavelength according to the set channel.

Next, the controller 50 determines whether the wavelength of the lasing light is within a required range according to the detection result of the wavelength detector 30 (Step S16), similarly to Step S14. If it is not determined that the wavelength of the lasing light is within the required range in Step S16, the controller 50 corrects the temperature of the temperature control device 20 (Step S21). After that, the controller 50 executes Step S16 again.

If it is determined that the wavelength of the lasing light is within the required range in Step S16, the controller 50 determines whether the optical intensity of the lasing light is within a required range (Step S17). In concrete, the controller 50 obtains the target value Im1 for feedback control from the look-up table 51, obtains the detection result Im1 of the light-receiving element in the output detector 40, and determines whether the detection result Im1 is within a given range including the target value Im1 for feedback control.

If it is not determined that the optical intensity of the lasing light is within the required range in Step S17, the controller 50 corrects the current provided to the electrode 16 (Step S22). After that, the controller 50 executes Step S17 again.

If it is determined that the optical intensity of the lasing light is within the required range in Step S17, the controller 50 determines whether the heat value of the heater 14 is within a required range (Step S18), similarly to Step S13. If it is not determined whether the heat value of the heater 14 is within the required range in Step S18, the controller 50 corrects the electrical power to the heater 14 (Step S23). After that, the controller 50 executes Step S18 again. If it is determined that the electrical power provided to the heat value of the heater 14 is within the required range in the Step S18, the controller 50 executes Step S16 again.

With the flowchart of FIG. 5, the heat value of the heater 14 is corrected accurately before the wavelength is controlled with the wavelength detector 30. In this case, the heat value of the heater 14 is substantially the same as a case where the heater is little degraded, even if the heater 14 is degraded. Therefore, the optical property of the SG-DBR region 11 is substantially the same as the case where the heater 14 is little degraded. This results in a desirable wavelength according to the initial setting value.

In the embodiment, the semiconductor laser has a combination of the SG-DBR region and the SG-DFB region. However, the structure is not so limited. For example, the present invention may be applied to a semiconductor laser in which an active region acting as a gain region is between a pair of SG-DBR regions. In this case, a heater is provided on each of the SG-DBR regions or one of the SG-DBR regions. In this case, it is possible to control in feedback so that the heat value of the heater is within the required range, if the thermistor detects the temperature of each heater.

The present invention may be applied to a CSG-DBR (Chirped Sampled Grating Distributed Bragg Reflector). In the CSG-DBR, space regions connecting gratings have a different length from each other, being different from the SG-DBR region. Therefore, there is wavelength dependence in a peak intensity of a reflection spectrum of the CSG-DBR region. In this case, the peak intensity of the reflection spectrum is enlarged in a given wavelength range. It is therefore possible to restrain oscillation at wavelengths other than a desired wavelength, if a wavelength in a wavelength range having relatively high intensity is used as a lasing wavelength. In a case where the CSG-DBR is used, it is possible to control the temperature of each segment separately, if each heater is provided on each segment structured with the grating and the spacer portion.

In the above-mentioned embodiment, the heat value of the heater is detected by detecting the electrical power provided to the heater with use of a voltmeter, a current meter or an electrical power meter. However, the structure is not limited. For example, the heat value of the heater may be detected with a thermistor.

In the flowchart of FIG. 4, the Step S3 corresponds to the first step. The Steps S1 to S3 correspond to the starting sequence. Step S4 corresponds to the second step. Steps S4 to S6 correspond to the wavelength control sequence. Step S6 corresponds to the third step. In the flowchart of FIG. 5, Step S13 corresponds to the first step. Steps S11 to S15 correspond to the starting sequence. Step S16 corresponds to the second step. Steps S16 to S18 correspond to the wavelength control sequence. Step S18 corresponds to the third step.

## Claims

1. A method of controlling a semiconductor laser (10) emitting a lasing light and having a wavelength selection portion (11), the refractive index of the wavelength selection portion being controllable with a heater (14), the method comprising, in the order:
a starting sequence including a first step (S3, S13) for determining, by measuring the voltage applied to, and the current flowing through, the heater (14), whether the heat value of the heater (14) is within a given range and adjusting (S7, sl9) the heat value of the heater (14) until the heat value of the heater (14) reaches a given value within said given range; and
a wavelength control sequence including a second step for correcting (S8; S20) the wavelength of the semiconductor laser (10) by means of a temperature control device (20) and according to a detection result of the oscillation wavelength of the semiconductor laser (10) obtained (S4, S14) after the starting sequence and
a third step (S6, S18) for determining, by measuring the voltage applied to, and the current flowing through, the heater (14), whether the heat value of the heater (14) is within said given range, and adjusting (S10, S23) the heat value of the heater (14) until the heat value of the heater (14) reaches said given range.

2. A method as claimed in claim 1, wherein the heat value of the heater (14) is adjusted by adjusting the electrical power to the heater (14) in the first step.

3. A method as claimed in claim 1, wherein the heat value of the heater (14) is adjusted by adjusting the current provided to the heater (14) until the electrical power obtained with the voltage between both ends of the heater (14) and the current provided to the heater (14) reaches a given value in the first step.

4. A method as claimed in claim 1 or 2, wherein the heat value is adjusted by adjusting the electrical power provided to the heater (14) until the output of a temperature detector arranged near the heater (14) reaches a given value.

5. A method as claimed in any preceding claim, wherein the semiconductor laser (10) has a wavelength detector (30) for detecting the oscillation wavelength.

6. A method as claimed in any preceding claim, wherein the semiconductor laser (10) has an active region that has a diffraction grating and an optical waveguide that is optically connected to the active region and has a diffraction grating, the equivalent refractive index of the optical waveguide being tunable with the heater (14).

7. A method as claimed in claim 6, wherein the diffraction grating of the active region and the optical waveguide has a first region that has a diffractive grating and a second region that is connected to the first region and acts as a spacer.

8. A method as claimed in any of claims 1 to 5, wherein the semiconductor laser (10) has an active region and a pair of optical waveguides optically connected to both ends of the active region respectively, at least one of the optical waveguides having the heater (14) for controlling the equivalent refractive index thereof.

9. A method as claimed in claim 1, further comprising:
a dark-tuning sequence for tuning the wavelength to a predetermined value under a condition where the optical output is restrained, and performing the starting sequence; and
an optical output sequence outputting light, with the wavelength selected in the dark-tuning sequence being maintained.

## Patentansprüche

1. Verfahren zum Steuern eines Halbleiterlasers (10), der ein Laserlicht emittiert und ein Wellenlängenselektionsteil (11) hat,
wobei der Brechungsindex des Wellenlängenselektionsteils mit einem Heizer (14) steuerbar ist, wobei das Verfahren der Reihe nach enthält:
eine Startsequenz, die einen ersten Schritt (S3, S13) enthält, um durch Messen der Spannung und des Stroms, die angelegt ist an bzw. der fließt durch den Heizer (14), zu bestimmen, ob der Wärmewert des Heizers (14) innerhalb eines gegebenen Bereichs ist, und den Wärmewert des Heizers (14) einzustellen (S7, S19), bis der Wärmewert des Heizers (14) einen gegebenen Wert innerhalb des gegebenen Bereichs erreicht; und
eine Wellenlängen-Steuersequenz, die einen zweiten Schritt (S8, S20) zum Korrigieren der Wellenlänge des Halbleiterlasers (10) mittels einer Temperatur-Steuereinrichtung (20) und gemäß einem Detektionsergebnis der Oszillationswellenlänge des Halbleiterlasers (10), das nach der Startsequenz erhalten wurde (S4, S14), und einen dritten Schritt enthält, um durch Messen der Spannung und des Stroms, die angelegt ist an bzw. der fließt durch den Heizer (14), zu bestimmen, ob der Wärmewert des Heizers (14) innerhalb des gegebenen Bereichs ist, und den Wärmewert des Heizers (14) einzustellen (S10, S23), bis der Wärmewert des Heizers (14) den gegebenen Bereich erreicht.

2. Verfahren nach Anspruch 1, wobei der Wärmewert des Heizers (14) durch Einstellen der elektrischen Leistung zu dem Heizer (14) in dem ersten Schritt eingestellt wird.

3. Verfahren nach Anspruch 1, wobei der Wärmewert des Heizers (14) durch Einstellen des Stroms eingestellt wird, der an den Heizer (14) zur Verfügung gestellt wird, bis die elektrische Leistung, die mit der Spannung zwischen beiden Enden des Heizers (14) und dem dem Heizer (14) zur Verfügung gestellten Strom erhalten wird, in dem ersten Schritt einen gegebenen Wert erreicht.

4. Verfahren nach Anspruch 1 oder 2, wobei der Wärmewert durch Einstellen der elektrischen Leistung eingestellt wird, die dem Heizer (14) zur Verfügung gestellt wird, bis die Ausgabe eines Temperaturdetektors, der nahe dem Heizer (14) angeordnet ist, einen gegebenen Wert erreicht.

5. Verfahren nach einem der vorhergehenden Ansprüche, wobei der Halbeiterlaser (10) einen Wellenlängendetektor (30) zum Detektieren der Oszillationswellenlänge hat.

6. Verfahren nach einem der vorhergehenden Ansprüche, wobei der Halbeiterlaser (10) eine aktive Region, die ein Beugungsgitter hat, und einen optischen Wellenleiter hat, der optisch mit der aktiven Region verbunden ist und ein Beugungsgitter hat, wobei der Äquivalentbrechungsindex des optischen Wellenleiters mit dem Heizer (14) einstellbar ist.

7. Verfahren nach Anspruch 6, wobei das Beugungsgitter der aktiven Region und des optischen Wellenleiters eine erste Region, die ein Beugungsgitter hat, und eine zweite Region hat, die mit der ersten Region verbunden ist und als ein Abstandhalter wirkt.

8. Verfahren nach einem der Ansprüche 1 bis 5, wobei der Halbeiterlaser (10) eine aktive Region und ein Paar von optischen Wellenleitern hat, die optisch jeweils mit beiden Enden der aktiven Region verbunden sind, wobei wenigstens einer der optischen Wellenleiter den Heizer (14) zum Steuern des Äquivalentbrechungsindex davon hat.

9. Verfahren nach Anspruch 1, ferner enthaltend:
eine Dunkel-Einstellsequenz zum Einstellen der Wellenlänge auf einen vorgegebenen Wert unter einer Bedingung, in der die optische Ausgabe unterdrückt wird, und zum Ausführen der Startsequenz; und
eine optische Ausgabensequenz, die Licht ausgibt, wobei die Wellenlänge, die in der Dunkel-Einstellsequenz ausgewählt wurde, beibehalten wird.

## Revendications

1. Procédé de commande d'un laser à semi-conducteur (10) émettant une lumière laser et comportant une partie de sélection de longueur d'onde (11),
l'indice de réfraction de la partie de sélection de longueur d'onde étant modulable avec un dispositif de chauffage (14), le procédé comprenant, dans l'ordre :
une séquence initiale comprenant une première étape (S3, S13) pour déterminer, par mesure de la tension appliquée au, et du courant circulant à travers, le dispositif de chauffage (14), si la valeur thermique du dispositif de chauffage (14) est dans une plage donnée et ajuster (S7, S19) la valeur thermique du dispositif de chauffage (14) jusqu'à ce que la valeur thermique du dispositif de chauffage (14) atteigne une valeur donnée dans ladite plage donnée ; et
une séquence de contrôle de longueur d'onde comprenant une deuxième étape pour corriger (S8 ; S20) la longueur d'onde du laser à semi-conducteur (10) au moyen d'un dispositif de régulation de température (20) et en fonction d'un résultat de détection de la longueur d'onde d'oscillation du laser à semi-conducteur (10) obtenu (S4, S14) après la séquence de démarrage et
une troisième étape (S6, S18) pour déterminer, par mesure de la tension appliquée à, et du courant circulant à travers, le dispositif de chauffage (14), si la valeur thermique du dispositif de chauffage (14) est dans ladite plage donnée et ajuster (S10, S23) la valeur thermique du dispositif de chauffage (14) jusqu'à ce que la valeur thermique du dispositif de chauffage (14) atteigne ladite plage donnée.

2. Procédé selon la revendication 1, dans lequel la valeur thermique du dispositif de chauffage (14) est ajustée par ajustement de l'alimentation électrique du dispositif de chauffage (14) dans la première étape.

3. Procédé selon la revendication 1, dans lequel la valeur thermique du dispositif de chauffage (14) est ajustée par ajustement du courant fourni au dispositif de chauffage (14) jusqu'à ce que la puissance électrique obtenue avec la tension entre les deux extrémités du dispositif de chauffage (14) et le courant fourni au dispositif de chauffage (14) atteigne une valeur donnée dans la première étape.

4. Procédé selon la revendication 1 ou 2, dans lequel la valeur thermique est ajustée par ajustement de la puissance électrique fournie au dispositif de chauffage (14) jusqu'à ce que la sortie d'un détecteur de température agencé à proximité du dispositif de chauffage (14) atteigne une valeur donnée.

5. Procédé selon l'une quelconque des revendications précédentes, dans lequel le laser à semi-conducteur (10) comporte un détecteur de longueur d'onde (30) pour détecter la longueur d'onde d'oscillation.

6. Procédé selon l'une quelconque des revendications précédentes, dans lequel le laser à semi-conducteur (10) comporte une région active qui comporte un réseau de diffraction et un guide d'onde optique qui est optiquement connecté à la région active et comporte un réseau de diffraction, l'indice de réfraction équivalent du guide d'ondes optiques étant ajustable avec le dispositif de chauffage (14).

7. Procédé selon la revendication 6, dans lequel le réseau de diffraction de la région active et le guide d'ondes optiques comportent une première région qui a un réseau de diffraction et une deuxième région qui est reliée à la première région et sert d'élément d'espacement.

8. Procédé selon l'une quelconque des revendications 1 à 5, dans lequel le laser à semi-conducteur (10) comporte une région active et une paire de guides d'ondes optiques optiquement connectés aux deux extrémités de la région active, respectivement, au moins un des guides d'ondes optiques comportant le dispositif de chauffage (14) pour réguler l'indice de réfraction équivalent de celui-ci.

9. Procédé selon la revendication 1, comprenant en outre :
une séquence obscurité-ajustement pour ajuster la longueur d'onde à une valeur prédéterminée dans une condition dans laquelle la sortie optique est limitée, et exécuter la séquence de démarrage ; et
une séquence de sortie optique délivrant en sortie une lumière, avec la longueur d'onde sélectionnée dans la séquence obscurité-ajustement étant maintenue.
